# EUROPÄISCHE PATENTSCHRIFT

(11) **EP 2 412 096 B1**
(45) Veröffentlichungstag und Bekanntmachung des Hinweises auf die Patenterteilung: **02.12.2015**
(21) Anmeldenummer: 10711130.4
(22) Anmeldetag: 22.03.2010
(51) Int. Cl.: H03K 17/10, H03K 17/687

(54) **JFET-MOSFET KASKODESCHALTUNG**
JFET-MOSFET CASCODE CIRCUIT
CIRCUIT DU TYPE CASCODE JFET-MOSFET

(30) Priorität: 27.03.2009 CH 484092009
(43) Veröffentlichungstag der Anmeldung: 01.02.2012
(73) Patentinhaber: ETH Zurich, 8092 Zürich ETH-Zentrum (CH)
(72) Erfinder: BIELA, Jürgen, CH-8004 Zürich (CH); KOLAR, Johann, W., CH-8044 Zürich (CH); AGGELER, Daniel, CH-8044 Zürich (CH)
(74) Vertreter: Frei Patent Attorneys
(86) Internationale Anmeldenummer: PCT/CH2010/000078
(87) Internationale Veröffentlichungsnummer: WO 2010/108292

(56) Entgegenhaltungen:
- WO-A1-02/49215
- WO-A1-02/056472
- DE-A1- 19 902 520
- DE-B3- 10 350 170
- DE-C1- 10 135 835
- DE-C1- 19 610 135
- US-A- 6 157 049

## Beschreibung

Die Erfindung bezieht sich auf das Gebiet der elektronischen Schaltungstechnik und insbesondere auf eine Schalteinrichtung mit einer Kaskodeschaltung gemäss dem Oberbegriff von Patentanspruch 1.

### STAND DER TECHNIK

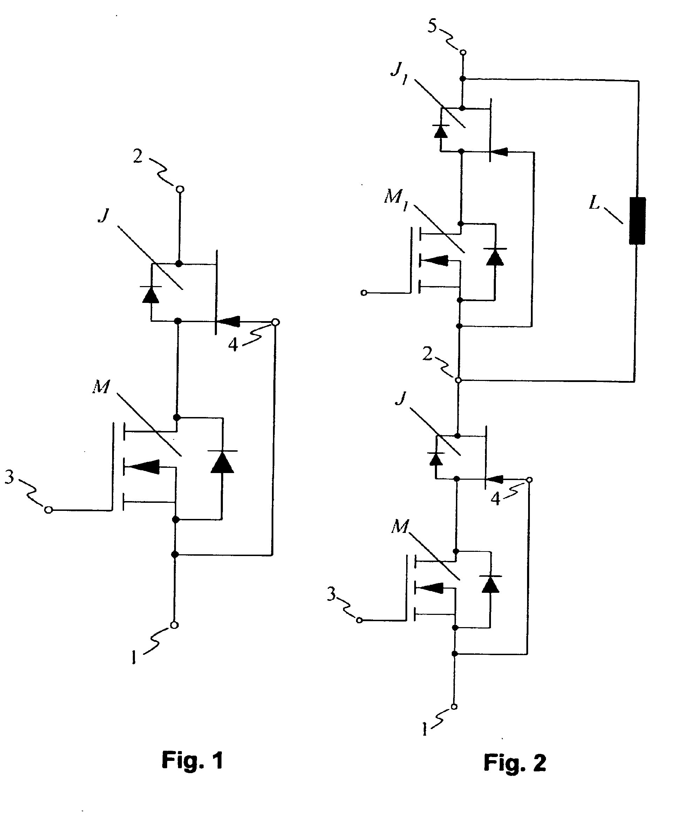

Elektronische Einrichtungen zum schnellen Schalten von elektrischen Strömen bei hohen Betriebsspannungen, insbesondere mit geringen Durchlassverlusten können nach DE 196 10 135 C1 oder US 6,157,049 realisiert werden. Dabei basiert die elektronische Einrichtung auf einer speziellen Zusammenschaltung eines MOSFETs M und einem JFET J (Junction Field Effect Transistor oder Sperrschicht-FET), illustriert durch **Figur 1****.** Die beiden Schalter sind zwischen einem ersten Anschluss 1 und einem zweiten Anschluss 2 angeordnet und werden durch einen Steueranschluss 3 des MOSFET M gesteuert.

Beispielhaft wird die Beschreibung des Standes der Technik und anschliessend auch der Erfindung im Folgenden für eine Halbbrückentopologie mit induktiver Last beschrieben, wie in der **Figur 2** gezeigt. Die Halbbrücke mit leistungselektronischen Schaltern M, J, M₁, J₁ und einer induktiven Last L verbunden zwischen dem dritten Anschluss 5 und dem zweiten Anschluss 2 zeigt eine typische Anordnung wie sie in vielen leistungselektronischen Systemen vorkommt. Eine untere Kaskodeschaltung zwischen dem ersten Anschluss 1 und dem zweiten Anschluss 2 wird durch einen unteren MOSFET M und einen unteren JFET J gebildet. Eine obere Kaskodeschaltung zwischen dem zweiten Anschluss 2 und dem dritten Anschluss 5 wird durch einen oberen MOSFET M₁ und einen JFET J₁ gebildet. Der dritte Anschluss 5 liegt dabei beispielsweise an einer Zwischenkreisspannung, der erste Anschluss 1 an einer entgegengesetzten Zwischenkreisspannung oder an einem Sternpunkt eines Mehrphasensystems. Dabei kann anstelle der oberen Kaskodeschaltung auch eine Diode mit dem Kathodenanschluss am dritten Anschluss 5 verwendet werden.

Ein eingeprägter Strom in der Induktivität L fliesst vom zweiten Anschluss 2 zum ersten Anschluss 1 wenn die untere Kaskodeschaltung eingeschaltet, also leitend ist. Beim Ausschalten des unteren MOSFETs M wird an den in Serie angeordneten unteren JFET J eine negative Pinch-off Spannung angelegt, welche den unteren JFET J sperrt. Dabei kommutiert der Strom von der unteren Kaskodeschaltung auf die obere Kaskodeschaltung. Der Strom fliesst dann durch die Induktivität L und vom zweiten Anschluss 2 durch die Kanal/Body-Dioden des oberen MOSFETs M₁ und des oberen JFETs J₁ zum dritten Anschluss 5. Die Kanal/Body-Dioden sind in den Figuren jeweils antiparallel zum jeweiligen Schalter eingezeichnet. Sie wirken hier also als antiparallele Freilaufdiode.

Aufgrund der parasitären Schalterkapazitäten infolge des Aufbaus der Schalter ist die Zeit für den Ladungstransport bzw. das Aufbauen der Sperrspannung für die Schalter vom Strom abhängig. Je grösser der Strom durch die Induktivität L, desto schneller findet die Kommutierung statt und desto schneller baut sich die Sperrspannung über den jeweiligen Schalter auf. Dies hat zur Folge, dass sehr hohe Werte der Spannungsänderung (du/dt) entstehen können, welche das EMV (elektromagnetische Verträglichkeit) Verhalten sehr stark beeinflussen können.

Das extrem hohe du/dt welches beim Einschalten dieser speziellen Zusammenschaltung von MOSFET und JFET erreicht werden kann, wenn die untere Kaskodeschaltung den Strom von den oberen Freilaufdioden abkommutiert, ist nicht abhängig vom Laststrom. Die resultierenden sehr steilen Spannungsflanken beim Einschalten können aber auch das EMV Verhalten stark beeinflussen.

Unterschiedliche Anwendungen fordern daher eine Kontrolle der Schaltgeschwindigkeit (sowohl beim Einschalten wie auch beim Ausschalten) und damit ein Verfahren die Spannungsflanken unabhängig vom Laststrom steuern zu können, um damit die eingekoppelten Störungen zu reduzieren oder zu eliminieren. In bekannten Verfahren für einzelne diskrete Transistoren werden dabei unter anderem die Gatetreiberschaltung modifiziert und dadurch schon eine bedeutende Steuerung der Kommutierung gewonnen, sowohl beim Einschalten als auch beim Ausschalten der Transistoren.

Eine weitere bekannte Möglichkeit um - bei einem einzelnen MOSFET - das du/dt Steuerverhalten zu beeinflussen ist, die dazugehörige Gate-Drain Kapazität zu vergrössern und somit den Gatestrom begrenzenden Miller-Effekt zu verlängern. Durch die zusätzliche Gate-Drain Kapazität wird die negative Rückkopplung vom Drain zum Gate verstärkt und insbesondere die Einschaltdauer sowie auch die Ausschaltdauer verlängert. Entsprechend werden die du/dt Werte kleiner.

In den speziellen Zusammenschaltungen von MOSFETs M und JFETs J können aber bekannte Methoden, wie das Modifizieren der Gatetreiberschaltung nicht verwendet werden, da dies nur das Verhalten des MOSFETs ändert und nicht das Verhalten des JFETs, an welchem die hohe Betriebsspannung angelegt wird.

WO-A-02/056472 und WO-A-02/49215 zeigen Schaltungen gemäss dem Oberbegriff von Patentanspruch 1, welche zur Beherrschung von hohen Strömen bei beispielsweise Anlaufvorgängen, Kurzschluss oder Überlast ausgelegt sind.

### DARSTELLUNG DER ERFINDUNG

Es ist deshalb Aufgabe der Erfindung, eine Schalteinrichtung und ein Verfahren zur Steuerung des du/dt Verhaltens der eingangs genannten Art zu schaffen, welche die oben genannten Nachteile behebt. Insbesondere ist eine Aufgabe, die Geschwindigkeit der Spannungsänderung an den Schaltern zu begrenzen oder auf ein vorgegebenes Mass einzustellen, ohne dass wichtige andere Eigenschaften der Schaltereinrichtung nachteilig beeinflusst werden.

Diese Aufgabe löst eine Schalteinrichtung mit einer Serieschaltung von MOSFET und JFET mit den Merkmalen des Patentanspruchs 1.

Die Schalteinrichtung zum Schalten eines Stromes zwischen einem ersten Anschluss und einem zweiten Anschluss weist also eine Kaskodeschaltung mit einer Serieschaltung von einem ersten Halbleiterschalter und einem zweiten Halbleiterschalter auf, wobei die beiden Halbleiterschalter über einem gemeinsamen Punkt miteinander verbunden sind, und
- der erste Halbleiterschalter mittels eines ersten Steuereingangs nach Massgabe einer Spannung zwischen dem ersten Steuereingang und dem ersten Anschluss angesteuert ist, und
- der zweite Halbleiterschalter mittels eines zweiten Steuereingangs nach Massgabe einer Spannung zwischen dem zweiten Steuereingang und dem gemeinsamen Punkt angesteuert ist.

Dabei ist zwischen dem zweiten Anschluss und mindestens einem der Steuereingänge eine Steuerschaltung mit einer Kapazität vorgebbarer Grösse geschaltet.

Die Kapazität vergrössert so die Drain-Gate Kapazität (parallel zur internen Drain-Gate Schalterkapazität), wobei vorzugsweise ein Dämpfungswiderstand dabei hilft, auftretende Oszillationen zu dämpfen und gleichzeitig den ladenden/entladenden Strom für die Kapazität zu begrenzen. Allgemein ist also die Steuerschaltung vorzugsweise ein RC-Glied.

Je grösser die Kapazität gewählt wird, desto grösser ist die negative Rückkopplung auf den Steuereingang und desto grösser ist der Miller-Effekt welcher dazu führt, dass die Einschaltgeschwindigkeit bzw. die Ausschaltgeschwindigkeit verlangsamt wird und somit die Steilheit von Spannungsänderungen auf niedrige Werte herabsetzt.

In einer bevorzugten Ausführungsform der Erfindung ist der erste Halbleiterschalter ein IGFET, insbesondere ein MOSFET, und ist der zweite Halbleiterschalter ein JFET. Der Einfachheit halber ist im Folgenden nur noch von einem MOSFET respektive einem JFET die Rede, wobei das Gesagte aber allgemein auch für in einer Kaskodeschaltung zusammenwirkende erste und zweite Halbleiterschalter gilt. Mit dem gebräuchlichen Begriff "MOSFET" sind in dieser Anmeldung jeweils auch die unter die allgemeinere Bezeichnung MISFET (Metall-Nichtleiter-Halbleiter-FET) oder ganz allgemein IGFET (FET mit isoliertem Gate) fallende Halbleiterbauelemente gemeint.

In einer weiteren bevorzugten Ausführungsform der Erfindung ist zwischen dem zweiten Steuereingang und dem ersten Anschluss eine Widerstandsanordnung geschaltet. Diese dient zur Verlangsamung eines Aufladevorgangs an einer inneren Kapazität zwischen dem Steuereingang und dem an dem zweiten Anschluss angeschlossenen Anschluss des zweiten Halbleiterschalters.

Die Widerstandsanordnung, beispielsweise ein einzelner Zusatzwiderstand stellt einen Einschaltwiderstand für den JFET dar. Insbesondere bildet dieser mit der Gate-Source Kapazität des JFETs ein weiteres RC-Glied und verlangsamt damit die Auf- bzw. Entladung der Gate-Source Kapazität des JFETs auf die Pinch-Off Spannung bzw. auf die Einschaltspannung von 0 Volt.

Durch den Zusatzwiderstand wird weiter auch der Ladungs- bzw. Entladungsstrom der Kapazität der Steuerschaltung begrenzt, wobei auch der Dämpfungswiderstand zu berücksichtigen ist. Infolge des Ladungs- bzw. Entladungsstromes der Kapazität liegt über dem Zusatzwiderstand kurzzeitig eine Spannung an, welche das Potential eines vierten Anschlusses (oder zweitem Steuereingang) zum Gateanschluss des JFET erhöht bzw. erniedrigt und folglich der Ausschaltung respektive auch der Einschaltung des JFETs entgegenwirkt.

In einer weiteren Ausführungsform der Erfindung wird ein zusätzlicher Vorwiderstand vor den Gateanschluss des JFETs, also zwischen dem Gateanschluss und dem vierten Anschluss, angeschlossen um damit eine möglichst optimale Ansteuerung des JFETs zu gewährleisten und insbesondere die Schaltgeschwindigkeit individuell zu bestimmen.

In einer anderen bevorzugten Ausführungsform der Erfindung wird die Schaltcharakteristik beim Einschalten und beim Ausschalten unabhängig voneinander eingestellt und werden somit unterschiedliche du/dt Werte bzw. synchronisierte du/dt Werte erreicht, indem ein weiteres Netzwerk zwischen dem vierten und dem ersten Anschluss angeschlossen wird. Dieses Netzwerk mit Dioden und unterschiedlichen Dämpfungswiderständen kann für das Einschalten- bzw. für das Ausschalten des JFETs separat ausgelegt und optimiert werden.

Grundsätzlich kann das RC-Glied als Steuerschaltung zwischen dem vierten und zweiten Anschluss auch eine Parallelschaltung sein, oder eine Parallelschaltung mit anpassbaren Dämpfungswiderständen für das Ein- bzw. Ausschalten oder eine individuell anpassbare Parallelschaltung, in welcher sowohl Dämpfungswiderstände als auch die Kapazitäten dem Einschaltverhalten bzw. dem Ausschaltverhalten angepasst werden können.

In einer weiteren bevorzugten Ausführungsform der Erfindung wird eine Kapazität zwischen einem dritten Anschluss (oder erstem Steuereingang) und dem zweiten Anschluss angebracht. Dabei ist der erst Steuereingang gleich dem Gateanschluss des MOSFET. Dadurch wirkt die negative Rückkopplung des zweiten Anschlusses auf den Gateanschluss des MOSFETs, infolge der zusätzlich benötigten Ladungsträger welche von der Gatetreiberschaltung nicht geliefert werden können wird der Miller-Effekt vergrössert und das Miller Plateau verlängert und somit die Schaltgeschwindigkeit beim Einschalten wie auch beim Ausschalten reduziert.

Die Kapazität zwischen dem zweiten und dritten Anschluss kann grundsätzlich auch vor eine (nicht invertierende) Verstärkerschaltung angeschlossen werden und dann die Verstärkerschaltung an den dritten Anschluss.

Weitere bevorzugte Ausführungsformen gehen aus den abhängigen Patentansprüchen hervor.

### KURZE BESCHREIBUNG DER ZEICHNUNGEN

Im Folgenden wird der Erfindungsgegenstand anhand von bevorzugten Ausführungsbeispielen, welche in den beiliegenden Zeichnungen dargestellt sind, näher erläutert. Es zeigen jeweils schematisch:
- Figur 1: eine Serienschaltung eines MOSFET und eines Sperrschicht-FETs gemäss dem Stand der Technik;
- Figur 2: eine beispielhafte Anwendung einer solchen Schaltung gemäss dem Stand der Technik;
- Figur 3: eine erste Ausführungsform der Erfindung;
- Figur 4: eine zweite Ausführungsform der Erfindung;
- Figur 5: eine dritte Ausführungsform der Erfindung mit unterschiedlichen Varianten einer Steuerschaltung;
- Figur 6: eine vierte Ausführungsform der Erfindung; und
- Figur 7: eine fünfte Ausführungsform der Erfindung.

Grundsätzlich sind in den Figuren gleiche Teile mit gleichen Bezugszeichen versehen.

### WEGE ZUR AUSFÜHRUNG DER ERFINDUNG

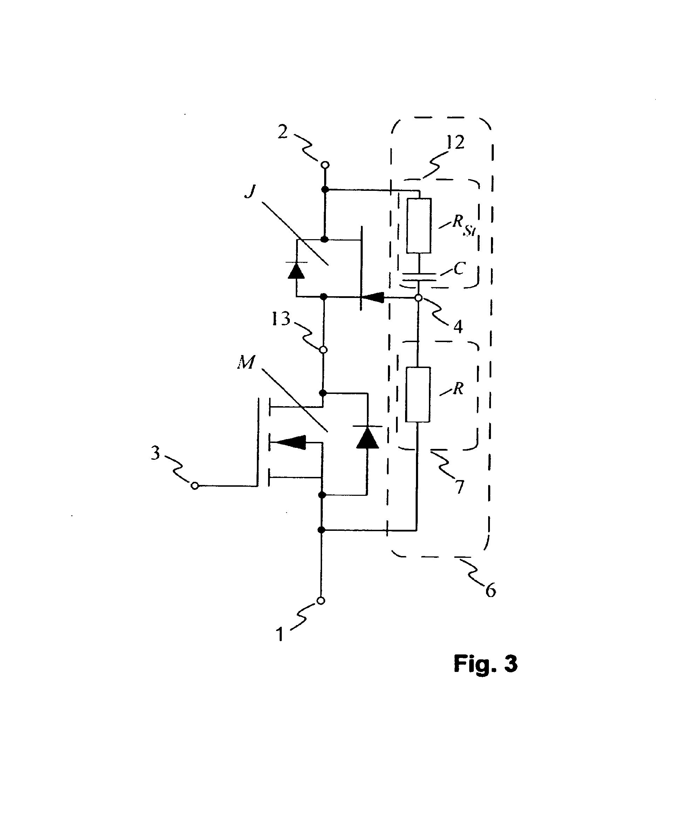

**Figur 3** zeigt eine erste Ausführungsform der Erfindung: Eine einzelne Schalteinrichtung, typischerweise als Teil einer umfassenderen Schalteranordnung beispielsweise in einem Umrichter, weist eine Kaskodeschaltung mit einem ersten und einem zweiten Halbleiterschalter auf. Hier und in den nachfolgenden Beispielen ist jeweils von JFET und MOSFET-Schaltem die Rede, und in den Figuren sind n-Kanal Halbleiterelemente gezeichnet. Die Erfindung lässt sich jedoch in analoger Weise auch mit p-Kanal-Elementen, bei umgekehrter Polarität und auch für Bipolartransistoren realisieren.

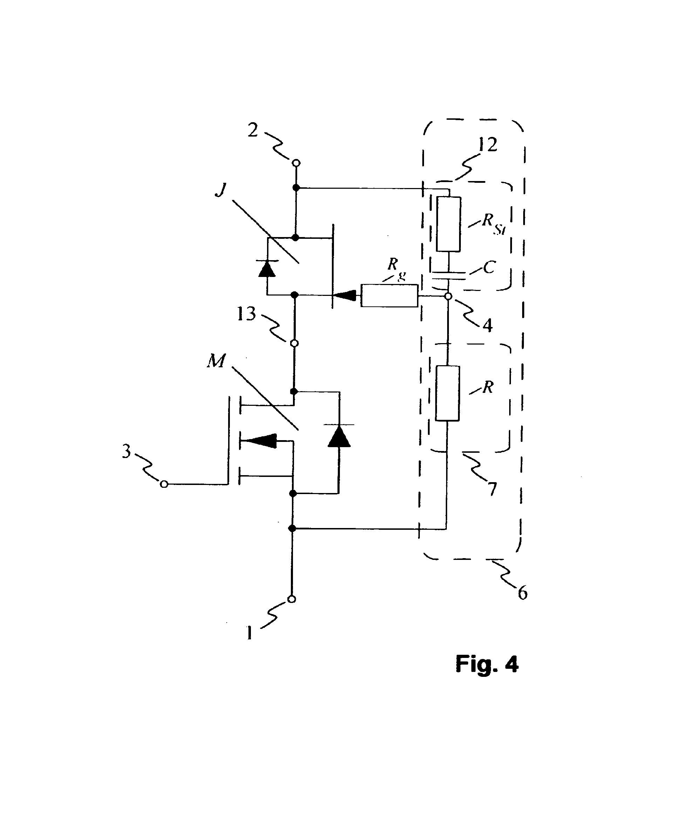

Die Schalteinrichtung der **Figur 3** wie auch der **Figuren 4-7** kann, entsprechend vervielfacht, in einem oder mehreren Brückenzweigen entsprechend der Struktur der Figur 2 eingesetzt werden.

Die Schalteinrichtung weist also einerseits zwei Halbleiterschalter auf, in den gezeigten Ausführungsformen jeweils einen JFET J und einen MOSFET M (respektive IGFET) in einer Kaskodeschaltung. Es ist also der MOSFET M als erster Halbleiterschalter zwischen einem ersten Anschluss 1 und einem gemeinsamen Anschluss 13 und der JFET J als zweiter Halbleiterschalter zwischen dem gemeinsamen Anschluss 13 und dem zweiten Anschluss 2 geschaltet. Der MOSFET M ist über seinen Gate-Anschluss 3 als ersten Steuereingang 3 angesteuert. Der JFET J ist über seinen Gate-Anschluss angesteuert. In einer Kaskodeschaltung gemäss dem Stand der Technik wäre der Gate-Anschluss des JFET J direkt mit dem ersten Anschluss verbunden, und es ergibt sich die Steuerung des JFET J entsprechend der Gate-Source-Spannung.

In einer Ausführungsform der Erfindung ist nun eine Steuerschaltung 12 mit einer Kapazität C vorgebbarer Grösse zwischen einem zweiten Steuereingang 4 und dem zweiten Anschluss 2 geschaltet. Dieser zweite Steuereingang 4 ist entweder direkt mit dem Gate-Anschluss des JFET J verbunden, also elektrisch gesehen identisch mit dem Gate-Anschluss **(****Figur 3****),** oder über einen vorgebbaren Vorwiderstand R_{g} mit dem Gate-Anschluss des JFET J verbunden **(****Figur 4****).**

Die Steuerschaltung 12 weist in einer ersten Variante gemäss **Figur 3** und **Figur 4** eine Serieschaltung der Kapazität C mit einem Dämpfungswiderstand R_{St} auf. Zusätzlich zur Steuerschaltung kann eine Widerstandsanordnung 7 zwischen dem zweiten Steuereingang 4 und dem ersten Anschluss 1 angeordnet sein. Die Widerstandsanordnung 7 und die Steuerschaltung 12 bilden zusammen ein Beschaltungsnetzwerk 6 für den zweiten Steuereingang 4. Das Beschaltungsnetzwerk 6 erlaubt das kontrollierte Beeinflussen der Schaltzeiten der Kaskodeschaltung in der folgenden Weise:
- Die Kapazität C erhöht die Miller-Kapazität des JFETs J respektive der ganzen Kaskodeschaltung.
- Der Dämpfungswiderstand R_{St} verhindert Schwingungen, die aufgrund der Kapazität C auftreten könnten.
- Die Widerstandsanordnung 7 mit beispielsweise dem optionalen Zusatzwiderstand R verlangsamt einen Aufladevorgang an einer inneren Kapazität zwischen Gate und Drain des JFETs J.
- Der optionale Vorwiderstand Rg bewirkt eine Verzögerung in der Sperr- bzw. Einschaltreaktion des JFETs J und verlangsamt, zusammen mit dem Zusatzwiderstand R, zusätzlich die Auf- bzw. Entladung einer inneren Kapazität zwischen Gate und Source des JFETs J.

Aufgrund der relativ kleinen Sperrspannung, die über dem ersten Halbleiterschalter anliegt, ist die Beeinflussung der Schaltzeiten für die Kaskodeschaltung durch den Vorwiderstand Rg gegenüber dem Einfluss des Zusatzwiderstands R relativ gering. Trotzdem kann es vorteilhaft sein, den Vorwiderstand Rg zur Einstellung der Schaltzeiten gezielt zu wählen. Es muss aber darauf geachtet werden, dass der totale Widerstand, resultierend aus der Serieschaltung des Zusatzwiderstandes R und des Vorwiderstandes Rg, nicht zu gross gewählt wird, um die thermische Beanspruchung zwischen Source und Gate des JFETs (im Avalanche Betrieb der parasitären Diode zwischen Source und Gate) zu beschränken. Daher ist der Vorwiderstand Rg relativ klein (unterer Ohm-Bereich) gegenüber dem Zusatzwiderstand R zu wählen, unabhängig von der Schaltgeschwindigkeit und der Betriebsspannung.

Grundsätzlich lässt sich die Schaltgeschwindigkeit über die Kapazität C der Steuerschaltung wie auch über den Zusatzwiderstand R beeinflussen. Unter Berücksichtigung von beispielsweise geometrischen Randbedingungen und der oben beschriebenen thermischen Begrenzung der Grösse des erlaubten Zusatzwiderstandes R ist eine Kombination der beiden Werte zu wählen. Die verbleibenden Parameter sind sekundär, und werden zur Strombegrenzung oder zur Entladung bei den Kapazitäten dimensioniert.

Im Folgenden wird ein Beispiel für eine Wahl der Steuerschaltungen und der Widerstandsanordnung zum Erreichen einer gewünschten Schaltgeschwindigkeit einer Kaskodeschaltung gemäss der Figur 3 gegeben: bei einer Zwischenkreisspannung von 400 V und einem Kommutierungsstrom von 4 A, geschieht die Beeinflussung des du/dt Verhaltens wie folgt: Mit Parametern wie C = 100 pF und *Rₛₜ* = 100 Ω für die Steuerschaltung 12 und einem Widerstand R = 47 Ω für die Widerstandsanordnung 7 resultiert eine Geschwindigkeit der Spannungsänderungen du/dt von 3.8 kV/µs anstelle von 32 kV/µs ohne Beschaltungsnetzwerk.

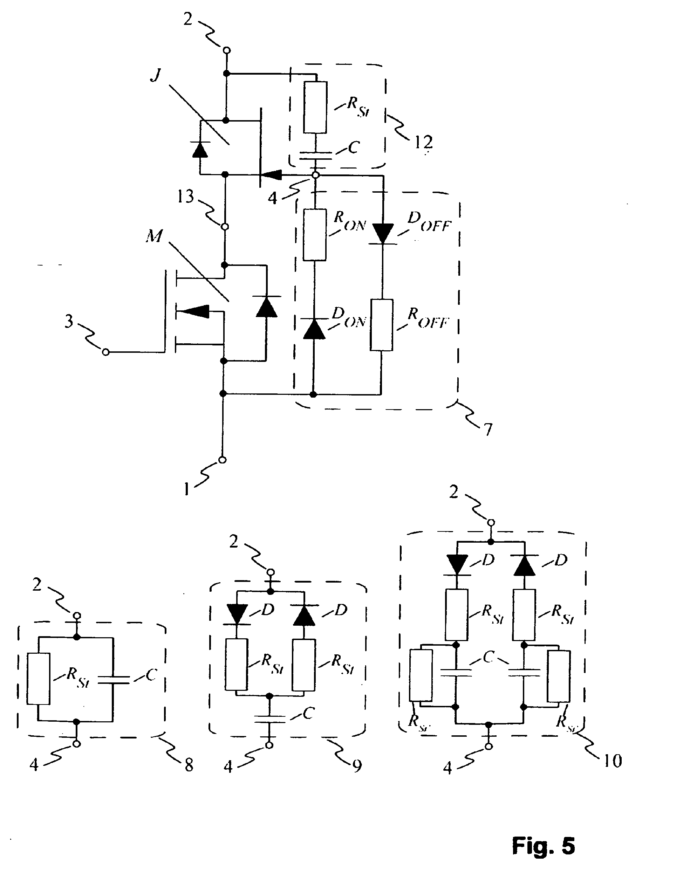

**Figur 5** zeigt eine dritte Ausführungsform der Erfindung mit unterschiedlichen Varianten einer Steuerschaltung 8, 9, 10, 12 und einer weiteren Variante der Widerstandsanordnung 7. Die gezeigte Variante der Widerstandsanordnung 7 weist Auswahldioden D_{ON}, D_{OFF} auf, mittels welcher weitere Zusatzwiderstände R_{ON}, R_{OFF} mit unterschiedlichen Widerstandswerten entsprechend der Richtung des Stromflusses durch die Widerstandsanordnung 7 selektierbar sind. Dadurch wird der eine weitere Zusatzwiderstand R_{ON}, beim Einschalten und der andere Zusatzwiderstand R_{OFF} beim Aussschalten wirksam. Die weiteren Varianten 8, 9, 10 der Steuerschaltung sind
- eine zweite Variante 8 mit einer Parallelschaltung der Kapazität C und des Dämpfungswiderstand R_{St};
- eine dritte Variante 9 mit der Kapazität C in Serie mit zwei parallelen, jeweils durch antiparallele Dioden D entsprechend der Stromrichtung auswählbaren Dämpfungswiderständen R_{St} (welche zweckmässigerweise unterschiedliche Widerstandswerte aufweisen);
- eine vierte Variante 10 mit zwei parallelen, jeweils durch antiparallele Dioden D entsprechend der Stromrichtung auswählbaren Ästen, wobei jeder der Äste einen Dämpfungswiderstand R_{St} in Serie mit einer Parallelschaltung einer Kapazität C mit einem weiteren Dämpfungswiderstand R_{St}' aufweist. Damit lassen sich, wie auch in der dritten Variante, die Schaltzeiten und die Steilheiten der Spannungsänderungen für den Ein- und Ausschaltvorgang separat vorgeben, wobei auch die Kapazitäten C für das Einschalten und das Ausschalten separat wählbar sind. Die weiteren Dämpfungswiderstände R_{St}' dienen auch der Entladung der Kapazitäten C, da dies hier über die Dioden D nicht in jedem Fall möglich ist.

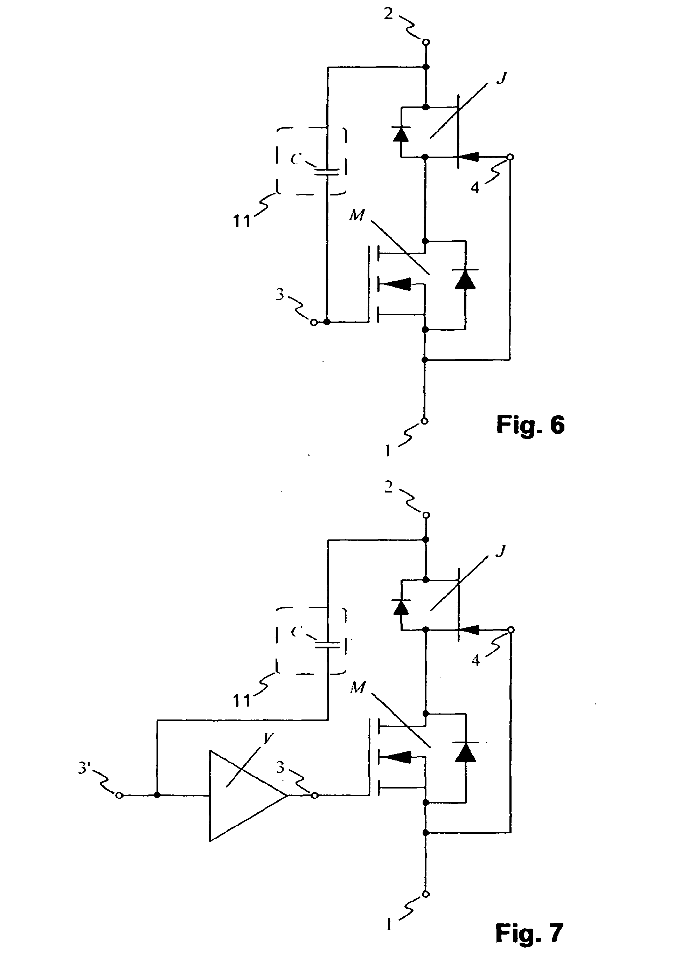

**Figur 6** zeigt eine vierte Ausführungsform der Erfindung, in welcher die Steuerschaltung 11 zwischen dem zweiten Anschluss 2 und einem ersten Steuereingang 3 des ersten Halbleiterschalters, also des MOSFETs M respektive IGFETs geschaltet ist, wobei dieser erste Steuereingang 3 gleich dem Gate-Anschluss des MOSFET M ist.

Der Ausgangswiderstand der Schaltung, welche das Steuersignal am Steuereingang 3 erzeugt, bildet in dieser Ausführungsform mit der Steuerschaltung 11 wie auch mit der Gate-Source Kapazität des MOSFETs M jeweils ein RC-Glied. Diese beiden auftretenden RC-Glieder erlauben das kontrollierte Beeinflussen der Schaltzeiten der Kaskodeschaltung in der folgenden Weise:
- Der Ausgangswiderstand vergrössert die Zeitkonstanten beider RC-Glieder.
- Das RC-Glied mit der parasitären Kapazität des MOSFETs M beeinflusst das Ein- bzw. das Ausschaltverhalten des MOSFETs, wobei die parasitäre Kapazität durch dessen Aufbau gegeben ist. Je grösser der Ausgangswiderstand, desto grösser ist die Zeitkonstante des Auf- bzw. Entladungsvorgangs des Kondensators, nach dem Gesetz *τ = R·C.* In der speziellen Anordnung der Kaskodeschaltung bewirkt ein grösserer Vorwiderstand eine grössere Verzögerung bis zum Einsetzen der gesamten Schalthandlung.
- Das RC-Glied mit der Steuerschaltung 11 und dem Vorwiderstand beeinflusst die Schaltgeschwindigkeit der Kaskodeschaltung nach dem Einsetzen der Schalthandlung. Das RC-Glied ist optimierbar auf die Anwendung der Schalteinrichtung und die gewünschte Schaltgeschwindigkeit. Durch den Ausgangswiderstand wird der durch die negative Rückkopplung der Miller-Kapazität benötigte Strom begrenzt.

**Figur 7** zeigt eine fünfte Ausführungsform der Erfindung, in welcher die Steuerschaltung 11 zwischen dem zweiten Anschluss 2 und einem ersten Steuereingang 3' des unteren Halbleiterschalters, also des MOSFETs M respektive IGFETs geschaltet ist, wobei hier der erste Steuereingang 3' an einem nicht invertierenden Eingang 3' eines Treiberverstärkers V zur Ansteuerung des Gate-Anschlusses des MOSFET M angeschlossen ist.

In den Ausführungsformen der **Figuren 6** und **7** tritt ebenfalls der Miller-Effekt durch Rückkopplung auf den ersten Steuereingang auf, und dadurch auch die gewünschte einstellbare Verzögerung der Schaltvorgänge der Kaskodeschaltung. Die Steuerschaltung 11 ist beispielhaft als einzelne Kapazität C gezeichnet, es lassen sich aber auch andere Varianten 8, 9, 10 der Steuerschaltung, wie beispielsweise in der Figur 5 gezeigt, einsetzen, um die Dämpfung einzustellen und um Ein- und Ausschaltvorgänge unabhängig voneinander zu beeinflussen.

Es versteht sich, dass immer wenn im vorliegenden Text die Rede davon ist, dass zwei Elemente miteinander verbunden sind, jeweils eine elektrische Verbindung der Elemente gemeint ist.

## Patentansprüche

1. Schalteinrichtung zum Schalten eines Stromes zwischen einem ersten Anschluss (1) und einem zweiten Anschluss (2), aufweisend eine Kaskodeschaltung mit einer Serieschaltung von einem ersten Halbleiterschalter (M) und einem zweiten Halbleiterschalter (J), wobei die beiden Halbleiterschalter (M, J) über einem gemeinsamen Punkt (13) miteinander verbunden sind, und
der erste Halbleiterschalter (M) mittels eines ersten Steuereingangs (3, 3') nach Massgabe einer Spannung zwischen dem ersten Steuereingang (3, 3') und dem ersten Anschluss (1) angesteuert ist, und
der zweite Halbleiterschalter (J) mittels eines zweiten Steuereingangs (4) nach Massgabe einer Spannung zwischen dem zweiten Steuereingang (4) und dem gemeinsamen Punkt (13) angesteuert ist,
**dadurch gekennzeichnet, dass** zwischen dem zweiten Anschluss (2) und mindestens einem der Steuereingänge (3, 3', 4) eine Steuerschaltung (8, 9, 10, 11, 12) mit einer Kapazität (C) vorgebbarer Grösse geschaltet ist.

2. Schalteinrichtung gemäss Anspruch 1, wobei die Steuerschaltung (8, 9, 10, 12) zwischen den zweiten Anschluss (2) und dem zweiten Steuereingang (4) geschaltet ist.

3. Schalteinrichtung gemäss Anspruch 1 oder 2, wobei der zweite Steuereingang (4) gleich einem Gate-Anschluss oder Basis-Anschluss des zweiten Halbleiterschalters (J) ist, oder der zweite Steuereingang (4) über einen vorgebbaren Vorwiderstand (R_{g}) mit dem Gate-Anschluss oder dem Basis-Anschluss des zweiten Halbleiterschalters (J) verbunden ist.

4. Schalteinrichtung gemäss Anspruch 1, wobei die Steuerschaltung (11) zwischen den zweiten Anschluss (2) und dem ersten Steuereingang (3, 3') geschaltet ist.

5. Schalteinrichtung gemäss Anspruch 4, wobei der erste Steuereingang (3, 3') gleich einem Gate-Anschluss (3) oder Basis-Anschluss des ersten Halbleiterschalters (M) ist, oder gleich einem nicht invertierenden Eingang (3') eines Treiberverstärkers (V) zur Ansteuerung des Gate-Anschlusses (3) oder des Basis-Anschlusses des ersten Halbleiterschalters (M) ist.

6. Schalteinrichtung gemäss einem der bisherigen Ansprüche, wobei die Steuerschaltung (8, 9, 10, 11, 12) eine Kapazität (C) in Serie mit einem Dämpfungswiderstand (R_{St}) oder parallel zu einem Dämpfungswiderstand (R_{St}) aufweist.

7. Schalteinrichtung gemäss einem der Ansprüche 1 bis 6, wobei die Steuerschaltung (8, 9, 10, 11, 12) zwei parallele Äste mit Kapazitäten (C) und/oder Dämpfungswiderständen (R_{St}) aufweist, und die beiden Äste antiparallele Dioden (D) aufweisen, so dass je nach Polarität einer an der Steuerschaltung anliegenden Spannung der eine oder der andere der beiden Äste stromdurchflossen ist.

8. Schalteinrichtung gemäss einem der bisherigen Ansprüche, wobei zwischen dem zweiten Steuereingang (4) und dem ersten Anschluss (1) eine Widerstandsanordnung (7) angeordnet ist.

9. Schalteinrichtung gemäss Anspruch 8 wobei die Widerstandsanordnung (7) einen einzelnen Widerstand als Zusatzwiderstand (R) aufweist.

10. Schalteinrichtung gemäss Anspruch 8, wobei die Widerstandsanordnung (7) eine Parallelschaltung aus je einer Serieschaltung einer Auswahldiode (D_{ON}, D_{OFF}) mit einem weiteren Zusatzwiderstand (R_{ON}, R_{OFF}) aufweist, wobei die beiden Dioden antiparallel zueinander geschaltet sind.

11. Schalteinrichtung gemäss einem der bisherigen Ansprüche, wobei der erste Halbleiterschalter (M) ein IGFET, insbesondere ein MOSFET ist.

12. Schalteinrichtung gemäss einem der bisherigen Ansprüche, wobei der zweite Halbleiterschalter (J) ein JFET ist.

13. Schalteinrichtung gemäss einem der bisherigen Ansprüche, wobei die Steuerschaltung (8, 9, 10, 11, 12) und weitere Elemente (7) eines Beschaltungsnetzwerkes (6) so parametriert sind, dass beim Ein- und/oder Ausschalten der Steuerschaltung eine Geschwindigkeit der Spannungsänderung über der Schalteinrichtung im Vergleich mit der Schalteinrichtung ohne Beschaltungsnetzwerk (6) mindestens zweimal, fünfmal oder zehnmal kleiner ist.

## Claims

1. A switching device for switching a current between a first terminal (1) and a second terminal (2), comprising a cascode circuit with a series connection of a first semiconductor switch (M) and a second semiconductor switch (J), wherein the two semiconductor switches (M, J) are connected to one another via a common point (13), and
the first semiconductor switch (M) is activated by way of a first control input (3, 3') in accordance with a voltage between the first control input (3,3') and the first terminal (1), and
the second semiconductor switch (J) is activated by way of a second control input (4) in accordance with a voltage between the second control input (4) and the common point (13),
**characterised in that** a control circuit (8, 9, 10, 11, 12) with a capacitance (C) of a presettable size is connected between the second terminal (2) and at least one of the control inputs (3, 3', 4).

2. A switching device according to claim 1, wherein the control circuit (8, 9, 10, 12) is connected between the second terminal (2) and the second control input (4).

3. A switching device according to claim 1 or 2, wherein the second control input (4) is equal to a gate terminal or base terminal of the second semiconductor switch (J), or the second control input (4) is connected via a presettable series resistance (Rg) to the gate terminal or the base terminal of the second semiconductor switch (J).

4. A switching device according to claim 1, wherein the control switch (11) is connected between the second terminal (2) and the first control input (3,3')

5. A switching device according to claim 4, wherein the first control input (3,3') is the same as a gate terminal (3) or base terminal of the first semiconductor switch (M), or is the same as a non-inverting input (3') of a driver amplifier (V) for activating the gate terminal (3) or the base terminal of the first semiconductor switch (M).

6. A switching device according to one of the preceding claims, wherein the control circuit (8, 9, 10, 11, 12) comprises a capacitance (C) in series with a damping resistance (R_{St}) or parallel to a damping resistance (R_{St}).

7. A switching device according to one of the claims 1 to 6, wherein the control circuit (8, 9, 10, 11, 12) comprises two parallel branches with capacitances (C) and/or damping resistances (R_{St}), and the two branches comprise antiparallel diodes (D), so current flows through the one or the other of the two branches depending on the polarity of a voltage prevailing at the control circuit.

8. A switching device according to one of the preceding claims, wherein a resistance arrangement (7) is arranged between the second control input (4) and the first terminal (1).

9. A switching device according to claim 8, wherein the resistance arrangement has a single resistance as an additional resistance (R).

10. A switching device according to claim 8, wherein the resistance arrangement (7) comprises a parallel connection in each case of a series connection of a selection diode (D_{ON}, D_{OFF}) to a further additional resistance (R_{ON}, R_{OFF}), wherein the two diodes are connected antiparallel to one another.

11. A switching device according to one of the preceding claims, wherein the first semiconductor switch (M) is an IGFET, in particular a MOSFET.

12. A switching device according to one of the preceding claims, wherein the second semiconductor switch (J) is a JFET.

13. A switching device according to one of the preceding claims, wherein the control circuit (8, 9, 10, 11, 12) and further elements (7) of a circuitry network (6) are parameterised such that when switching the control circuit on and/or off, a speed of the voltage change over the switching device is at least twice, five times or ten times lower in comparison to the switching device without a circuitry network.

## Revendications

1. Dispositif de commutation destiné à commuter un courant entre une première borne de raccordement (1) et une deuxième borne de raccordement (2), présentant un circuit cascode doté d'un raccordement en série d'un premier commutateur (M) à semi-conducteur et d'un deuxième commutateur (J) à semi-conducteur, les deux commutateurs (M, J) à semi-conducteur étant raccordés l'un à l'autre par un point commun (13),
le premier commutateur (M) à semi-conducteur étant commandé au moyen d'une première entrée de commande (3, 3') en fonction d'une tension présente entre la première entrée de commande (3, 3') et la première borne de raccordement (1) et
le deuxième commutateur (J) à semi-conducteur étant commandé au moyen d'une deuxième entrée de commande (4) en fonction de la tension présente entre la deuxième entrée de commande (4) et le point commun (13), **caractérisé en ce que**
un circuit de commande (8, 9, 10, 11, 12) dont la capacité (C) peut présenter une valeur prédéterminée, est raccordé entre la deuxième borne de raccordement (2) et au moins l'une des entrées de commande (3, 3', 4).

2. Dispositif de commutation selon la revendication 1, dans lequel le circuit de commande (8, 9, 10, 12) est raccordé entre la deuxième borne de raccordement (2) et la deuxième entrée de commande (4).

3. Dispositif de commutation selon les revendications 1 ou 2, dans lequel la deuxième entrée de commande (4) est la borne de raccordement de grille ou la borne de raccordement de base du deuxième commutateur (J) à semi-conducteur ou dans lequel la deuxième entrée de commande (4) est raccordée par une pré-résistance (R_{g}) de valeur prédéterminée à la borne de raccordement de grille ou à la borne de raccordement de base du deuxième commutateur (J) à semi-conducteur.

4. Dispositif de commutation selon la revendication 1, dans lequel le circuit de commande (11) est raccordé entre la deuxième borne de raccordement (2) et la première entrée de commande (3, 3').

5. Dispositif de commutation selon la revendication 4, dans lequel la première entrée de commande (3, 3') est la borne de raccordement de grille (3) ou la borne de raccordement de base du premier commutateur (M) à semi-conducteur, ou équivaut à une entrée non inversante (3') d'un amplificateur opérationnel (V) qui commande la borne de raccordement de grille (3) ou la borne de raccordement de base du premier commutateur (M) à semi-conducteur.

6. Dispositif de commutation selon l'une des revendications précédentes, dans lequel le circuit de commande (8, 9, 10, 11, 12) présente une capacité (C) raccordée en série à une résistance d'atténuation (Rₛₜ) ou en parallèle à une résistance d'atténuation (Rₛₜ).

7. Dispositif de commutation selon l'une des revendications 1 à 6, dans lequel le circuit de commande (8, 9, 10, 11, 12) présente deux branches parallèles dotées de capacités (C) et/ou de résistances d'atténuation (Rₛₜ), les deux branches présentant des diodes (D) antiparallèles qui, selon la polarité de la tension appliquée sur le circuit de commande, font traverser l'une ou l'autre des deux branches par un courant.

8. Dispositif de commutation selon l'une des revendications précédentes, dans lequel un ensemble de résistance (7) est disposé entre la deuxième entrée de commande (4) et la première borne de raccordement (1).

9. Dispositif de commutation selon la revendication 8, dans lequel l'ensemble de résistance (7) présente une seule résistance servant de résistance supplémentaire (R).

10. Dispositif de commutation selon la revendication 8, dans lequel l'ensemble de résistance (7) présente un raccordement en parallèle de circuits série formés d'une diode de sélection (D_{ON}, D_{OFF}) et d'une deuxième résistance supplémentaire (R_{ON}, R_{OFF}) , les deux diodes étant raccordées l'une à l'autre de manière antiparallèle.

11. Dispositif de commutation selon l'une des revendications précédentes, dans lequel le premier commutateur (M) à semi-conducteur est un IGFET et en particulier un MOSFET.

12. Dispositif de commutation selon l'une des revendications précédentes, dans lequel le deuxième commutateur (J) à semi-conducteur est un JFET.

13. Dispositif de commutation selon l'une des revendications précédentes, dans lequel le circuit de commande (8, 9, 10, 11, 12) et d'autres éléments (7) d'un réseau de raccordement (6) sont paramétrisés de telle sorte que lors du branchement et/ou du débranchement du circuit de commande, la vitesse de modification de la tension aux bornes du dispositif de commutation soit au moins deux fois, cinq fois ou dix fois plus petite que pour le dispositif de commutation sans réseau de raccordement (6).
